# EUROPEAN PATENT APPLICATION

(11) **EP 4 468 341 A1**
(43) Date of publication of application: **27.11.2024**
(21) Application number: 22926378.5
(22) Date of filing: 15.02.2022
(51) Int. Cl.: H01L 23/492, H01L 21/58, H01L 25/18

(54) **SYSTEM-IN-PACKAGE DEVICE, ELECTRONIC DEVICE, AND SYSTEM-IN-PACKAGE DEVICE MANUFACTURING METHOD**

(71) Applicant: Huawei Technologies Co., Ltd., Shenzhen, Guangdong 518129 (CN)
(72) Inventor: ZHANG, Lei, Shenzhen, Guangdong 518129 (CN); CHEN, Zunmiao, Shenzhen, Guangdong 518129 (CN); SHI, Lin, Shenzhen, Guangdong 518129 (CN); LIU, Bo, Shenzhen, Guangdong 518129 (CN); WANG, Jing, Shenzhen, Guangdong 518129 (CN); FAN, Guicheng, Shenzhen, Guangdong 518129 (CN)
(74) Representative: Goddar, Heinz J.
(86) International application number: PCT/CN2022/076328
(87) International publication number: WO 2023/155040

(57) **Abstract**

This application provides a system-in package component, an electronic device, and a system-in package component manufacturing method, to improve compatibility flexibility of a PCB with a component, reduce an area of the PCB, and reduce costs of the PCB. The system-in package component includes: a first carrier board; a plurality of electronic components, separately disposed on the first carrier board, where the first carrier board is configured to implement an electrical connection between at least two electronic components of the plurality of electronic components, and at least one electronic component of the plurality of electronic components includes a packaged integrated circuit; and a packaging material, configured to package the plurality of electronic components on the first carrier board.

## Description

### TECHNICAL FIELD

This application relates to the field of electronic technologies, and in particular, to a system-in package component, an electronic device, and a system-in package component manufacturing method.

### BACKGROUND

Currently, more components are integrated into a printed circuit board (printed circuit board, PCB) in an electronic device. Consequently, the PCB needs to have more metal layers and insulation layers, and an area of the PCB becomes larger. Too many PCB layers cause high costs, and an area of the PCB becomes larger, which occupies a large amount of space of the electronic device, and does not facilitate miniaturization of the electronic device. In addition, all components on the PCB need to meet PCB power supply, wiring, solder ball distance, input/output (input/output, I/O) pin layout, and I/O depth constraints (a PCB constraint for short). These constraints cause poor PCB compatibility flexibility, and some components that do not meet the constraints cannot be used in the PCB.

### SUMMARY

This application provides a system-in package component, an electronic device, and a system-in package component manufacturing method, to improve compatibility flexibility of a PCB with a component, reduce an area of the PCB, and reduce costs of the PCB.

According to a first aspect, an embodiment of this application provides a system-in package component that may include a first carrier board, a plurality of electronic components disposed on the first carrier board, and a packaging material. The first carrier board may implement an electrical connection between at least two electronic components in the plurality of electronic components. The first carrier board may support signal interaction, electric energy transmission, or the like of the at least two electronic components. At least one electronic component of the plurality of electronic components in the system-in package component provided in this application may include a packaged integrated circuit. The packaging material may package the plurality of electronic components on the first carrier board.

In embodiments of this application, the system-in package component may package, to the first carrier board, an electronic component on an original PCB or an electronic component that does not meet a PCB constraint, so that the electronic component may be connected to the PCB via the first carrier board. The plurality of electronic components in the system-in package component may not be disposed on the PCB, but are packaged to the first carrier board, to reduce a quantity of components integrated into the PCB, so that the PCB has fewer metal layers and insulation layers, and costs of the PCB are reduced. In addition, an area that is of the PCB and that is occupied by the component may be reduced, and the PCB may have a smaller area, to implement PCB miniaturization, so that occupied space of the electronic device is reduced and miniaturization of the electronic device is facilitated. The plurality of electronic components in the system-in package component may implement functions via the first carrier board, or may be electrically connected to other electronic components via the first carrier board. In this way, the electronic components in the system-in package component are electrically connected without a need of the PCB. The electronic component on the first carrier board may include a packaged integrated circuit. The packaged integrated circuit is packaged to the first carrier board, and may not affect an electronic component on the PCB. The packaged integrated circuit may be an integrated circuit that has been packaged. For example, the packaged integrated circuit may be a packaged chip instead of a bare chip. In some scenarios, for example, in a scenario in which a component integrated into the PCB is adjusted, the packaged integrated circuit may not need to comply with the PCB constraint. The system-in package component provided in embodiments of this application may facilitate an electrical connection, performed via the first carrier board, between the PCB and an electronic component that does not comply with the PCB constraint, so that the electronic component that does not comply with the PCB constraint may be integrated into the PCB, to improve compatibility flexibility of the PCB with the electronic component. Compared with redesigning the PCB, the system-in package component provided in embodiments of this application enables the PCB to be compatible with the electronic component that does not comply the PCB constraint, and the PCB does not need to be discarded. Such a design has low costs. In addition, the packaged integrated circuit is additionally disposed on the first carrier board of the system-in package component, and the area of the PCB does not need to be occupied. This reduces the area that is of the PCB and that is occupied by the packaged integrated circuit and improves an integration level of the PCB.

In a possible design, the plurality of electronic components further include at least one discrete component. The discrete component may be a packaged component, or referred to as a component that has been packaged. In some examples, the at least one discrete component may be one or more of the following components: a capacitor, a resistor, a filter, a power supply assembly, and a storage assembly. In other words, the capacitor, the resistor, the filter, the power supply assembly, the storage assembly, and the like may be further disposed on the first carrier board. The system-in package component may package the capacitor, the resistor, the filter, the power supply assembly, the storage assembly, and the like together with the packaged integrated circuit on the first carrier board. The electrical connection between the electronic components on the first carrier board is performed without a need of the PCB, in other words, the electrical connection between the electronic components on the first carrier board is invisible to the PCB. In some scenarios, some electronic components such as discrete components and chips on the PCB may be disposed on the first carrier board, and the first carrier board is used for re-packaging. This can reduce an occupied area of the PCB, and improve an integration level of the PCB.

In a possible design, the first carrier board may have a first surface. At least one first contact may be disposed on the first surface. The first contact may be configured to connect one of the plurality of electronic components. In the system-in package component provided in embodiments of this application, the first carrier board has one or more first contacts, and can be connected to the electronic component. When an adjusted functional module does not meet the PCB constraint or an adjusted electronic component does not meet the PCB constraint, the functional module may be electrically connected to the PCB by connecting the first contact on the first carrier board.

In a possible design, the first contact on the first carrier board may include one or more of a solder ball and a solder pad, so that the first carrier board in the system-in package component may be electrically connected to the electronic component of the plurality of electronic components via the solder ball or the solder pad. The electronic components on the first carrier board may interact with each other without using the PCB, so that the plurality of electronic components on the first carrier board are invisible to the PCB. Such a design can simplify a connection line between the PCB and the electronic component, and can also reduce a quantity of electronic components on the PCB.

In a possible design, when the first contact on the first carrier board includes a plurality of solder balls, a distance between two solder balls in the plurality of solder balls may be less than 1 mm, and/or the distance is greater than 0.3 mm. The distance between the two solder balls may not need to comply with the PCB constraint. A distance constraint between electronic components on the first carrier board may be low, and a component density on the first carrier board, for example, an I/O arrangement density, may be more flexible.

In some examples, the distance between the two solder balls may be 0.65 mm. It can be seen that a distance constraint between first electronic components that are respectively connected to the two solder balls on the first carrier board is low.

In a possible design, the first carrier board may include one or more substrate materials, so that an electronic component is formed or an electronic component is embedded in the first carrier board.

In a possible design, at least one electronic component is disposed on the first surface of the first carrier board. At least one electronic component of the plurality of electronic components may be formed on the first carrier board. This helps improve an integration level of the first carrier board, so that the integration level of the PCB is improved and the occupied area of the PCB is reduced.

In a possible design, at least one second contact is disposed on a second surface of the first carrier board, the second contact is configured to connect to the PCB, and the second surface is opposite to the first surface. In embodiments of this application, contact on the second surface of the first carrier board may be connected to the PCB. The first surface of the first carrier board may be connected to the electronic component in the plurality of electronic components, and the second surface may be connected to the PCB. This improves the integration level of the PCB.

In a possible design, the second contact disposed on the second surface of the first carrier board may include one or more of a solder ball and a solder pad. The second contact disposed on the second surface may comply with the PCB constraint, so that the first carrier board is connected to the PCB. The first surface and the second surface of the first carrier board may be separately connected to the plurality electronic components, to improve the integration level of the first carrier board, so that the occupied area of the PCB is reduced. In addition, the electronic components on the first carrier board may be invisible to the PCB, thereby simplifying a PCB interface.

In a possible design, at least one electronic component of the plurality of electronic components may be disposed on the second surface of the first carrier board. The electronic component is formed on the second surface of the first carrier board. It can be seen that more electronic components may be integrated into the first carrier board, and the first carrier board with a high integration level may help improve the integration level of the PCB.

In a possible design, at least one electronic component of the plurality of electronic components may be embedded in the first carrier board. The first electronic component may be further embedded in the first carrier board of the system-in package component provided in embodiments of this application, to further improve the integration level of the first carrier board. The first electronic component disposed on the first carrier board has a higher density, so that the first carrier board can support a high-density I/O arrangement.

In a possible design, a first electronic component in a first functional module disposed on the first carrier board is a packaged component, or a component that passes a functional test (functional test, FT). The packaged component and the component that passes the FT have a high yield rate. The electronic component in the first functional module disposed on the first carrier board is the packaged component or the component that passes the FT. This helps improve an overall yield rate of the PCB.

According to a second aspect, an embodiment of this application further provides an electronic device that may include a PCB and the system-in package component according to any one of the first aspect and the designs of the first aspect. A first carrier board of the system-in package component may be disposed on the PCB. An electronic component in a first functional module of the electronic device may be disposed on the first carrier board, and a second functional module may be disposed on the PCB. Such a design can reduce a quantity of electronic components disposed on the PCB, so that the PCB does not need to have a large quantity of metal layers and insulation layers, thereby reducing costs. In addition, the electronic component is disposed on the first carrier board, so that an occupied area of the PCB can be reduced, and the area of the PCB can be reduced. This helps reduce occupied space of the electronic device and miniaturize the electronic device. In some scenarios, the PCB may be compatible, via the system-in package component, with a functional module or an electronic component that does not comply with a PCB constraint. An I/O layout density of the system-in package component may be high, so that more electronic components are integrated, a quantity and connection lines of electronic components connected to the PCB are reduced, and an area that is occupied by the electronic components and that is of the PCB is reduced. The system-in package component can improve compatibility flexibility of the PCB, and help optimize performance of the electronic device.

According to a third aspect, an embodiment of this application further provides a system-in package component manufacturing method. The method includes: disposing a plurality of electronic components on a first carrier board, where the first carrier board is configured to implement an electrical connection between at least two electronic components of the plurality of electronic components, and at least one electronic component of the plurality of electronic components includes a packaged integrated circuit; and packaging the plurality of electronic components on the first carrier board by using a packaging material.

In embodiments of this application, the packaged integrated circuit is disposed on the first carrier board, and the integrated circuit is packaged to the first carrier board by using the packaging material. Such a design helps reduce an occupied area of a PCB connected to the first carrier board, and reduce costs of the PCB. Implementation costs are low, and a waste of resources caused by redesigning the PCB because the packaged integrated circuit does not meet a PCB constraint can be avoided.

In a possible design, the method further includes: disposing at least one discrete component on the first carrier board. In some scenarios, the discrete component and the packaged integrated circuit may be packaged together on the first carrier board by using the packaging material.

In a possible design, the at least one discrete component may include one or more of the following components: a capacitor, a resistor, a filter, a power supply assembly, and a storage assembly. In embodiments of this application, the electronic component disposed on the first carrier board may further include discrete components such as the capacitor, the resistor, the filter, the power supply assembly, and the storage assembly. Increasing a quantity and type of electronic components integrated into the first carrier board helps reduce the area of the PCB and reduce the costs of the PCB.

In a possible design, the method further includes: disposing the first carrier board on a printed circuit board PCB, to cause at least one electronic component on the first carrier board to be electrically connected to an electronic component on the PCB. In embodiments of this application, the first carrier board is disposed on the PCB, so that an electrical connection between the electronic component on the first carrier board and the electronic component on the PCB can be implemented.

In a possible design, the method further includes: forming the at least one electronic component on the first carrier board; or embedding at least one electronic component in the first carrier board. In embodiments of this application, to improve an integration level of the first carrier board, the electronic component may be formed on the first carrier board, or the electronic component may be embedded in the first carrier board.

For technical effects that may be achieved in the second aspect and the third aspect, refer to descriptions of technical effects that may be achieved in a corresponding design of the first aspect. Details are not described herein again.

### BRIEF DESCRIPTION OF DRAWINGS

FIG. 1 is a diagram of a structure of a PCB;
FIG. 2 is a diagram of a structure of a system-in package component;
FIG. 3 is a diagram of a specific structure of a system-in package component;
FIG. 4 is a diagram of a specific structure of another system-in package component; and
FIG. 5 is a situation diagram of a PCB not connected to a system-in package component and a PCB connected to a system-in package component.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in description of this application, "at least one" means one or more, and "a plurality of" means two or more. In view of this, "a plurality of" may also be understood as "at least two" in embodiments of the present invention. The term "and/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects. In addition, it should be understood that in description of this application, terms such as "first" and "second" are merely used for distinguishing and description, but should not be understood as indicating or implying relative importance, or should not be understood as indicating or implying a sequence.

It should be noted that the "connection" in embodiments of this application may be understood as an electric connection, and a connection between two electrical elements may be a direct or indirect connection between the two electrical elements. For example, a connection between A and B may be a direct connection between A and B, or may be an indirect connection between A and B through one or more other electrical elements. For example, that A is connected to B may also be that A is directly connected to C, C is directly connected to B, A and B are connected through C. In some scenarios, the "connection" may also be understood as coupling, for example, electromagnetic coupling between two inductors. In conclusion, the connection between A and B enables transmission of electric energy between A and B.

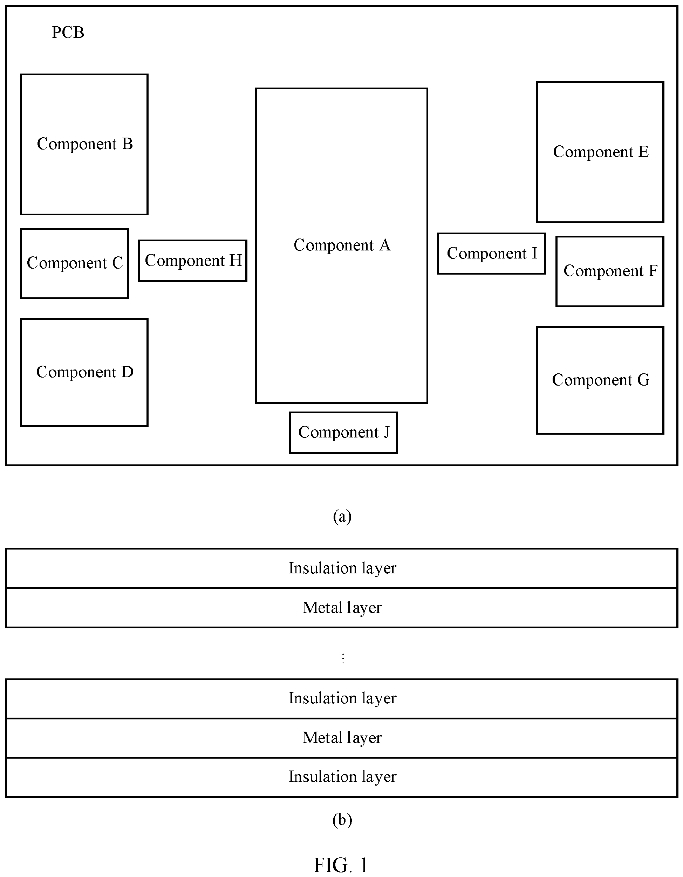

After a PCB in an electronic device is delivered from a factory, a plurality of functional modules may be disposed on the PCB, and components in each functional module are integrated into the PCB. As shown in (a) in FIG. 1, it is assumed that electronic components included in the plurality of functional modules on the PCB are denoted as a component A, a component B, a component C, a component D, a component E, a component F, a component G, a component H, a component I, a component I, and a component J. The component A to the component J are all integrated into the PCB, and each component is connected to the PCB. Components can interact with each other via the PCB. As shown in (b) in FIG. 1, an existing PCB integrates all electronic components, and needs to be provided with more metal layers and insulation layers, and consequently, costs of the PCB are high. In addition, an area of the PCB is large, and consequently, the costs of the PCB are high.

After the PCB is delivered from a factory, the electronic components added to the PCB need to meet a PCB constraint, such as power supply, wiring, solder ball distance, I/O (pin) layout, and I/O depth constraints. Therefore, only electronic components that meet the PCB constraint can be used on the PCB.

Generally, a manner of adjusting a chip or a component on the PCB of the electronic device is used to optimize the electronic device, for example, improve signal processing performance or reduce costs of the electronic device. For example, a chip or a component with better performance or a smaller size is used. However, due to the PCB constraint, it is difficult to use another chip or component, and consequently, PCB compatibility flexibility is poor. It is difficult to apply another chip or component that can optimize the electronic device to the PCB, and it is also difficult to optimize the electronic device. However, if the PCB is redesigned, to directly integrate the chip or the component that can improve performance of the electronic device into a new PCB, the original PCB is directly discarded in this manner, which is wasteful and has high costs.

For example, the component A on the PCB may be a packaged integrated circuit, for example, a chip-type component. Compared with the component A, a component 1 has higher performance. If the component 1 replaces the component A to perform a function, signal processing performance of the electronic device can be improved. However, in an actual application scenario, an I/O pin of the component 1 may not comply with an I/O layout constraint of the PCB. Consequently, the component 1 cannot be integrated into the PCB. If the PCB is redesigned to use the component 1, costs are too high. In addition, the original PCB is directly discarded, which is wasteful.

In view of this, embodiments of this application provide a system-in package component, to improve compatibility flexibility of a PCB with a component, reduce an area of the PCB, reduce costs of the PCB, and optimize device performance.

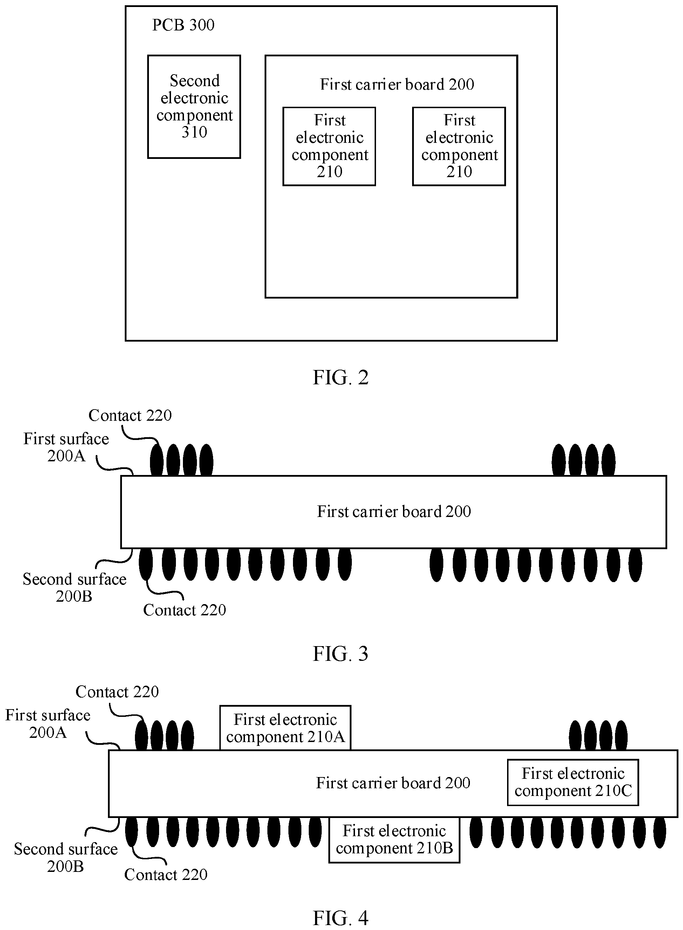

Refer to FIG. 2. A system-in package component may include a first carrier board 200, a plurality of first electronic components 210, and a package material. The plurality of first electronic components 210 may be disposed on the first carrier board 200. The first carrier board 200 may implement an electrical connection between at least two first electronic components in the plurality of first electronic components 210. The packaging material may package the plurality of first electronic components 210 on the first carrier board 200. The first carrier board 200 may be connected to a PCB 300. The PCB 300 may be provided with at least one second electronic component 310. For ease of distinguishing, an electronic component disposed in the PCB is denoted as the second electronic component.

The first electronic components 210 are disposed on the first carrier board 200 rather than integrated on the PCB 300, which may reduce a quantity of electronic components integrated into the PCB 300. The PCB 300 may have a small quantity of metal layers or insulation layers, and may support a connection between second electronic components 310, so that the PCB 300 has low costs. In addition, the PCB 300 is connected to the first electronic components 210 via the first carrier board 200, so that a quantity of electronic components integrated into the PCB 300 is reduced. This helps reduce an area of the PCB 300 and facilitate miniaturization of the PCB 300.

In some examples, the first electronic component that is disposed on the first carrier board 200 and that is in the first electronic components 210 may be the foregoing component 1, namely, a packaged integrated circuit, or the like. The component 1 may not meet a PCB 300 constraint and cannot be integrated into the PCB. The component 1 may be packaged to the first carrier board 200, and is electrically connected to another first electronic component 210 on the first carrier board 200 via the first carrier board 200. The component 1 may interact with the PCB 300 via the first carrier board 200. Therefore, the component 1 is integrated into the PCB 300 via the first carrier board 200, and can replace another component, to improve performance of an electronic device.

In some examples, the plurality of first electronic components 210 may be disposed on the first carrier board 200. The plurality of first electronic components 210 may include a first electronic component 210A and a first electronic component 210B. The first carrier board 200 may implement an electrical connection between a first electronic component of the first electronic component 210A and a first electronic component of the first electronic component 210B, to implement interaction between the first electronic component 210A and the first electronic component 210B.

In embodiments of this application, the plurality of first electronic components 210 may interact with each other via the first carrier board 200 without a need of the PCB 300. Alternatively, first electronic components in the first electronic component 210 may interact with each other via the first carrier board 200 without a need of the PCB 300. Therefore, the first electronic component 210 may not need to meet the PCB 300 constraint. The system-in package component provided in embodiments of this application can improve compatibility flexibility of the PCB 300 with the electronic component, and the PCB does not need to be redesigned. This reduces compatibility costs of the PCB 300 with the electronic component.

As shown in FIG. 3, one or more contacts 220 may be disposed on a first surface 200A of a first carrier board 200. The contact 220 may be connected to a first electronic component 210. As shown in FIG. 2, the contact 220 may include a solder ball (ball pitch), and the solder ball may be configured to connect to the first electronic component. Alternatively, the contact 220 may include a solder pad, and the solder pad is configured to connect to the first electronic component. Alternatively, the contact 220 may include a solder pad and a solder ball, the solder ball may be disposed on the solder pad, and the solder ball may be configured to connect to the first electronic component.

One or more contacts 220 may be disposed on a second surface 200B of the first carrier board 200, and the contact 220 on the second surface 200B may be configured to connect to a PCB 300, to implement an electrical connection between the first carrier board 200 and the PCB 300. The first electronic component 210 disposed on the first carrier board 200 may be electrically connected to the PCB 300 via the first carrier board 200, so that a first electronic component of the first electronic component 210 may interact with a second electronic component 310 of the PCB 300.

The contact 220 on the second surface 200B may include a solder ball, and the solder ball may be configured to connect to the PCB 300. Alternatively, the contact 220 may include a solder pad, and the solder pad is configured to connect to the PCB 300. Alternatively, the contact 220 may include a solder pad and a solder ball, the solder ball may be disposed on the solder pad, and the solder ball may be configured to connect to the PCB 300.

In a possible design, when a plurality of solder balls are disposed on the first surface 200A, there may be two solder balls in the plurality of solder balls on the first surface 200A, where a first distance d1 between the two solder balls may be less than or equal to 1 mm. In some examples, the first distance d1 may be greater than or equal to 0.3 mm. For example, the first distance d1 may satisfy 0.3 ≤ d1 ≤ 1. In some scenarios, the first distance d1 may be 0.65 mm.

In some examples, a distance between any two of the plurality of solder balls on the first surface 200A may be greater than or equal to the first distance d1. In other words, a minimum value of the distance between any two of the plurality of solder balls on the first surface 200A may be the first distance d1. Generally, a distance between any two of solder balls disposed on the PCB 300 is greater than the first distance d1.

Similarly, when a plurality of solder balls are disposed on the second surface 200B, there may be two solder balls in the plurality of solder balls on the second surface 200B, where a second distance d2 between the two solder balls may be less than or equal to 1 mm. In some examples, the second distance d2 may be greater than or equal to 0.3 mm. For example, the second distance d2 may satisfy 0.3 ≤ d2 ≤ 1. In some scenarios, the second distance d2 may be 0.65 mm.

In some examples, a distance between any two of the plurality of solder balls on the second surface 200B may be greater than or equal to the second distance d2. In other words, a minimum value of the distance between any two of the plurality of solder balls on the second surface 200B may be the second distance d2. Generally, the distance between any two of the solder balls disposed on the PCB 300 is greater than or equal to the second distance d2. Generally, a distance between any two solder balls that are on the second surface 200B and that are connected to the PCB 300 is greater than the second distance d2.

Compared with a solder ball distance constraint of the PCB 300, a solder ball distance on the first carrier board 200 may be smaller, so that a distance between the first electronic components connected to the first carrier board 200 may be shorter, and an electronic component layout density on the first carrier board 200 is improved. Such a design helps an I/O arrangement density of the first carrier board 200 be higher than an I/O arrangement density of the PCB 300. An integration level of the first carrier board 200 may be further improved, so that the first carrier board 200 occupies less space, to reduce an area occupied by the PCB 300.

To improve an integration level of the PCB 300, in the system-in package component provided in this application, at least one first electronic component 210 is disposed on the first surface 200A of the first carrier board 200. The first electronic component 210 may be a discrete component, namely, a packaged component, for example, a resistor, a capacitor, a filter, a power supply assembly, or a storage assembly. The discrete component may be coupled to the first carrier board 200 via the solder pad, the solder ball, or the like on the first surface 200A and/or the second surface 200B.

In a possible implementation, as shown in FIG. 4, at least one first electronic component 210 may be disposed on a first surface 200A of a first carrier board 200. The first electronic component disposed on the first surface 200A may be denoted as a first electronic component 210A. For example, the first electronic component 210A is formed on the first surface 200A of the first carrier board 200 by using a pattern process (or referred to as a printing process). In some scenarios, the first electronic component 210A may include but is not limited to electronic components such as a resistor, a capacitor, and an inductor.

Similarly, an integration level of a PCB 300 is further improved, and at least one first electronic component 210 may also be disposed on a second surface 200B of the first carrier board 200. Refer to FIG. 4 again. The at least one first electronic component may be formed on the second surface 200B of the first carrier board 200. The first electronic component disposed on the second surface 200B may be denoted as a first electronic component 210B. The first electronic component 210B may be an electronic component, for example, a resistor, a capacitor, or an inductor.

In a possible implementation, at least one first electronic component may be embedded in the first carrier board 200. Refer to FIG. 4 again. The first electronic component embedded in the first carrier board 200 may be denoted as a first electronic component 210C. The first electronic component 210C may be embedded in the first carrier board 200, in other words, the first electronic component 210C may be disposed inside the first carrier board 200, in other words, the first electronic component 210C may be disposed between the first surface 200A and the second surface 200B. Such a design can improve an integration level of the first carrier board 200, to improve the integration level of the PCB 300.

Based on the system-in package component provided in any one of the foregoing embodiments, the system-in package component may have low costs. The first carrier board 200 in the system-in package component may include one or more substrate materials. The first carrier board 200 may include a PCB material, or may include a package substrate material. The PCB material and the package substrate material may include a rigid printed circuit board material, for example, a paper substrate material, a composite substrate material, a fiberglass fabric substrate material, a resin-coated copper foil, a metal substrate, or a ceramic substrate, may further include a flexible plate material, for example, a polyester film flexible copper clad laminate material or a polyimide film flexible copper clad laminate material, and may further include a ceramic substrate material, for example, aluminum oxide, aluminum nitride, or silicon carbide. A small quantity of electronic components are integrated into the first carrier board 200, and a large quantity of layers may not be needed, so that costs of the system-in package component are low.

Based on the system-in package component provided in any one of the foregoing embodiments, when a plurality of first electronic components 210 are disposed on the first carrier board 200 of the system-in package component, the plurality of first electronic components 210 may include a packaged integrated circuit. The packaged integrated circuit may also be referred to as a packaged chip, and is neither a bare chip nor a wafer. The system-in package component may further include a package material, and the package material may package the plurality of first electronic components 210 on the first carrier board 200. It can be seen that, in this example, the system-in package component may be configured to package the packaged integrated circuit and a discrete component together.

In some scenarios, each first electronic component 210 on the first carrier board 200 may be a component that passes an FT. Alternatively, the first electronic component 210 may be a component that has been packaged and passes the FT. Because yield rates of a packaged component and a component that passes the FT are high, when the system-in package component electrically connects the packaged component and the component that passes the FT to the PCB 300, a yield rate of the PCB 300 can be improved.

Based on the system-in package component provided in any one of the foregoing embodiments, interaction between the plurality of first electronic components 210 on the first carrier board 200, for example, signal transmission and electric energy transmission, may be implemented via the first carrier board 200, and the interaction between the plurality of first electronic components 210 on the first carrier board 200 may be implemented without a need of the PCB 300, or is irrelevant to the PCB 300. Such a design can simplify the PCB 300.

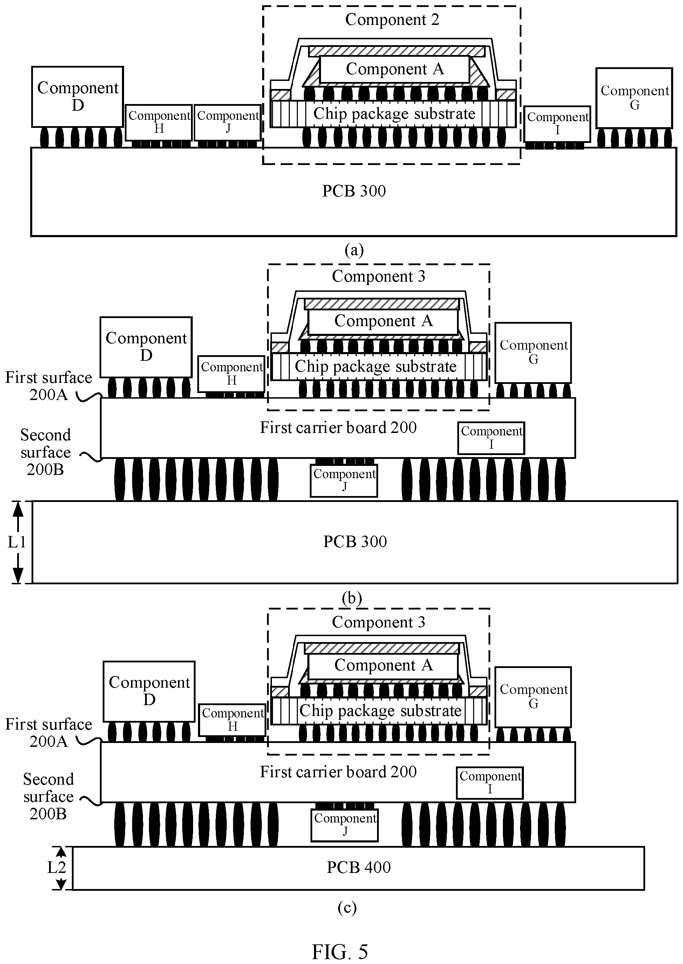

For example, as shown in (a) in FIG. 5, if the PCB 300 is not connected to the system-in package component, a component D and a component A that are disposed on the PCB 300 need to interact with each other via the PCB 300. For example, the component D sends an electrical signal to the component A via the PCB 300 or provides electric energy for the component A via the PCB 300. If the PCB 300 is connected to the system-in package component provided in embodiments of this application, the component D and the component A may be disposed on the first carrier board 200 of the system-in package component, and the component D sends an electrical signal to the component A via the first carrier board 200 or provides electric energy for the component A via the first carrier board 200. For the PCB 300, a process in which the component D sends the electrical signal to the component A or provides the electric energy for the component A is invisible. In other words, the process in which the component D sends the electrical signal to the component A or provides the electric energy for the component A is implemented without a need of the PCB 300.

In some possible optimization scenarios, refer to (a) in FIG. 5. The component A integrated into the PCB 300 may be a bare chip (which is an integrated circuit that is not packaged, and is usually a wafer). The bare chip is easily affected by a temperature and an impurity of an external environment, and is easily damaged. Therefore, the bare chip needs to be sealed in an enclosed space, and can be used as a basic component by leading out a corresponding pin. A packaged component A is denoted as component 2. The pin led out from the component 2 is an I/O pin, and can be directly integrated into the PCB 300 only when the I/O pin complies with constraints of an I/O layout and depth of the PCB 300.

The constraints of the I/O layout and depth of the PCB 300 after delivery are set. All components integrated into the PCB 300 need to comply with the constraints of the I/O layout and depth of the PCB 300. To optimize device performance, a package process of the component A is improved, so that performance of the component A can be improved. For ease of distinguishing, a component A packaged with an improved package process is denoted as a component 3. Compared with the component 2, the component 3 may have a smaller size and a larger I/O pin density, cannot meet constraints of the PCB 300 in terms of I/O layout, depth, and the like, and cannot be directly integrated into the PCB 300.

The component 3 may be disposed on the first carrier board 200 of any system-in package component provided in embodiments of this application. Refer to (b) in FIG. 5. The component 3 may be provided with a first surface 200A of the first carrier board 200 of the system-in package component. A second surface 200B of the first carrier board 200 may be connected to the PCB 300.

Compared with a distance between two solder balls on the second surface 200B of the first carrier board 200, a distance between two solder balls on the first surface 200A of the first carrier board 200 may be smaller, so that the solder ball on the first surface 200A may be connected to an I/O pin of the component 3. The component 3 may be connected to the PCB 300 via the first carrier board 200, to facilitate interaction with a component on the PCB 300. It can be learned that the system-in package component provided in embodiments of this application can facilitate the PCB 300 in connecting to a component that does not meet a PCB 300 constraint.

Still refer to (b) in FIG. 5. The first carrier board 200 of the system-in package component provided in embodiments of this application may be provided with a component that complies with the PCB 300 constraint, for example, a component D, a component G, a component H, and a component J. The component D, the component G, the component H, and the component J are disposed on the first carrier board 200, so that an area occupied by the PCB 300 can be reduced, and connection lines on the PCB 300 can be simplified. The component D, the component G, and the component H may be disposed on the first surface 200A of the first carrier board 200, and the component J may be disposed on the second surface 200B of the first carrier board 200, to improve an integration level of the first carrier board 200, reduce an area occupied by the first carrier board 200 on the PCB 300, and reduce packaging costs, for example, reduce a packaging size. In some scenarios, a quantity of packaging layers may be reduced in a manner of winding a carrier board.

In some possible designs, a component I may be embedded in the first carrier board 200. The component I may also be a component that complies with the PCB 300. The electronic component integrated into the PCB 300 is disposed on the first carrier board 200. Because the first carrier board 200 may have a higher I/O arrangement density, a position of the electronic component on the first carrier board 200 may be more flexible, to reduce a quantity of components on the PCB 300.

In a possible scenario, the electronic device to which the PCB 300 belongs may include a chip. Generally, the chip requires a plurality of operating voltages. The plurality of operating voltages may be separately provided by a plurality of power supply assemblies, and the plurality of power supply assemblies may be of different types. If the PCB 300 is not connected to the system-in package component, all power supply assemblies are disposed on the PCB 300. If the electronic device includes the system-in package component provided in embodiments of this application, the PCB 300 may be connected to the system-in package component provided in embodiments of this application, and some or all of the plurality of power supply assemblies may be disposed on the first carrier board 200. It can be learned that the system-in package component provided in embodiments of this application can help reduce power supply types of the PCB 300.

In another possible scenario, the electronic device to which the PCB 300 belongs may include a plurality of storage assemblies, and the plurality of storage assemblies may include a memory, for example, a double data rate (double data rate, DDR) synchronous dynamic random access memory. If the PCB 300 is not connected to the system-in package component, the plurality of storage assemblies are disposed on the PCB 300. If the electronic device includes the system-in package component provided in embodiments of this application, the PCB 300 may be connected to the system-in package component provided in embodiments of this application. Some or all of the plurality of storage assemblies may be disposed on the first carrier board 200 of the system-in package component, and some or all of the storage assemblies may be electrically connected to the PCB 300 via the first carrier board 200. In this design, connection lines of the storage assemblies on the PCB 300 can be reduced.

According to the foregoing description, the system-in package component provided in embodiments of this application can improve compatibility flexibility of the PCB 300 with a component. For example, a component that does not meet the PCB 300 constraint can be connected to the PCB 300 via the system-in package component. In addition, a position of an electronic component is adjusted from a functional module disposed on the PCB 300 to the system-in package component. The PCB 300 may be simplified. For example, connection lines on the PCB 300 may be simplified. A quantity of electronic components integrated into the PCB 300 may be reduced, so that a quantity of layers of the PCB 300 is reduced, a thickness of the PCB 300 is reduced, and costs of the PCB 300 are reduced. This facilitates miniaturization of the PCB 300.

An embodiment of this application further provides an electronic device that is denoted as a first electronic device. The first electronic device may include a PCB 300 and the system-in package component provided in any one of the foregoing embodiments. The system-in package component may be disposed on the PCB 300. For example, a contact 220 of a second surface 200B of a first carrier board 200 of the system-in package component may be connected to the PCB 300. A plurality of first electronic components 210 may be integrated into the first carrier board 200 of the system-in package component, which may reduce a quantity of components integrated into the PCB 300. In some scenarios, the PCB 300 may be compatible, via the system-in package component, with a functional module or an electronic component that does not comply with a PCB constraint. An I/O layout density of the system-in package component may be high, so that more electronic components are integrated, a quantity and connection lines of electronic components connected to the PCB are reduced, and an area that is occupied by the electronic components and that is of the PCB 300 is reduced. The system-in package component can improve compatibility flexibility of the PCB 300, and help optimize performance of the first electronic device.

Because the quantity of electronic components integrated into the PCB 300 is reduced, the PCB 300 may be replaced with a PCB having fewer layers, and costs of the PCB having fewer layers are lower. In view of this, an embodiment of this application further provides another electronic device, denoted as a second electronic device. The second electronic device may include a PCB 400 and the system-in package component provided in any one of the foregoing embodiments. The system-in package component may be disposed on the PCB 400. In the second electronic device, a plurality of first electronic components 210 may be disposed on the first carrier board 200, and a second electronic component 310 may be disposed on the PCB 400. Such a design avoids a case in which all electronic components are disposed on the PCB 400.

Compared with the PCB 300 in the first electronic device, the PCB 400 may have fewer layers and a smaller area. Refer to (b) in FIG. 5 and (c) in FIG. 5. A thickness L1 of the PCB 300 is greater than a thickness L2 of the PCB 400. In a thickness direction, an area S2 of the PCB 400 may be less than or equal to an area of the PCB 300. It can be seen that the PCB 400 may have lower costs and a smaller occupied area. It can be learned that costs of the second electronic device are lower, and because the PCB 400 has the smaller area, miniaturization of the second electronic device is facilitated.

It is clear that a person skilled in the art can make various modifications and variations to this application without departing from the protection scope of this application. This application is intended to cover these modifications and variations of this application provided that they fall within the scope of protection defined by the following claims and their equivalent technologies.

## Claims

1. A system-in package component, comprising:
a first carrier board;
a plurality of electronic components, separately disposed on the first carrier board, wherein the first carrier board is configured to implement an electrical connection between at least two electronic components of the plurality of electronic components, and at least one electronic component of the plurality of electronic components comprises a packaged integrated circuit; and
a packaging material, configured to package the plurality of electronic components on the first carrier board.

2. The component according to claim 1, wherein the plurality of electronic components further comprise at least one discrete component.

3. The component according to claim 2, wherein the at least one discrete component comprises one or more of the following:
a capacitor, a resistor, a filter, a power supply assembly, and a storage assembly.

4. The component according to any one of claims 1 to 3, wherein at least one first contact is disposed on a first surface of the first carrier board, and the first contact is configured to connect to the electronic component.

5. The component according to claim 4, wherein each first contact comprises one or more of a solder ball and a solder pad.

6. The component according to any one of claims 1 to 5, wherein at least one electronic component of the plurality of electronic components is disposed on the first surface.

7. The component according to any one of claims 1 to 6, wherein the first carrier board is disposed on a printed circuit board PCB; and the first carrier board is further configured to implement an electrical connection between the at least one electronic component of the plurality of electronic components and an electronic component on the PCB.

8. The component according to claim 7, wherein at least one second contact is disposed on a second surface of the first carrier board, the second contact is configured to connect to the PCB, and the second surface is opposite to the first surface.

9. The component according to claim 8, wherein the second contact comprises one or more of a solder ball and a solder pad.

10. The component according to claim 8 or 9, wherein at least one electronic component of the plurality of electronic components is disposed on the second surface.

11. The component according to any one of claims 1 to 10, wherein at least one electronic component is embedded in the first carrier board.

12. The component according to any one of claims 4 to 11, wherein the at least one first contact comprises a plurality of solder balls; a distance between two solder balls in the plurality of solder balls is less than or equal to 1 mm; and/or the distance is greater than or equal to 0.3 mm.

13. The component according to claim 12, wherein the distance is 0.65 mm.

14. The component according to any one of claims 1 to 13, wherein in the plurality of electronic components, each electronic component is a component that passes a functional test.

15. The component according to any one of claims 1 to 14, wherein the first carrier board comprises one or more substrate materials.

16. An electronic device, comprising a printed circuit board PCB and at least one system-in package component according to any one of claims 1 to 15 disposed on the PCB.

17. A system-in package component manufacturing method, wherein the method comprises:
disposing a plurality of electronic components on a first carrier board, wherein the first carrier board is configured to implement an electrical connection between at least two electronic components of the plurality of electronic components, and at least one electronic component of the plurality of electronic components comprises a packaged integrated circuit; and
packaging the plurality of electronic components on the first carrier board by using a packaging material.

18. The method according to claim 17, wherein the method further comprises:
disposing at least one discrete component on the first carrier board.

19. The method according to claim 18, wherein the at least one discrete component comprises one or more of the following:
a capacitor, a resistor, a filter, a power supply assembly, and a storage assembly.

20. The method according to any one of claims 17 to 19, wherein the method further comprises:
disposing the first carrier board on a printed circuit board PCB, to cause at least one electronic component on the first carrier board to be electrically connected to an electronic component on the PCB.

21. The method according to any one of claims 17 to 20, wherein the method further comprises:
forming the at least one electronic component on the first carrier board; or
embedding at least one electronic component in the first carrier board.
